(19) **Europäisches Patentamt / European Patent Office / Office européen des brevets**

(11) **EP 2 240 960 B1**

(12) **EUROPEAN PATENT SPECIFICATION**

(45) Date of publication and mention of the grant of the patent:
**14.03.2018 Bulletin 2018/11**

(51) Int Cl.:
**H01L 29/78** *(2006.01)*    **H01L 29/423** *(2006.01)*
**H02M 1/38** *(2007.01)*    **H02M 1/088** *(2006.01)*

(21) Application number: **09813383.8**

(22) Date of filing: **23.01.2009**

(86) International application number:
**PCT/US2009/031885**

(87) International publication number:
**WO 2010/030400 (18.03.2010 Gazette 2010/11)**

(54) **REGENERATIVE BUILDING BLOCK AND DIODE BRIDGE RECTIFIER AND METHODS**

REGENERATIVER AUFBAUBLOCK UND DIODENBRÜCKENGLEICHRICHTER SOWIE ENTSPRECHENDE VERFAHREN

BLOC FONCTIONNEL DE RÉGÉNÉRATION ET REDRESSEUR EN PONT À DIODES ET PROCÉDÉS CORRESPONDANTS

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **23.01.2008 US 22968 P**
**25.09.2008 US 238308**

(43) Date of publication of application:
**20.10.2010 Bulletin 2010/42**

(73) Proprietor: **STMicroelectronics N.V.**
**1228 Plan-les-Quates, Geneva (CH)**

(72) Inventors:
• **ANKOUDINOV, Alexei**
**Redmond, WA 98052 (US)**
• **RODOV, Vladimir**
**Seattle, WA 98146 (US)**

(74) Representative: **Style, Kelda Camilla Karen et al**
**Page White & Farrer**
**Bedford House**
**John Street**
**London, WC1N 2BF (GB)**

(56) References cited:
**US-A- 4 962 411      US-A- 4 962 411**
**US-A1- 2004 041 619      US-B1- 6 373 097**

**Description**

**RELATED APPLICATIONS**

**Field of the Invention**

The present invention relates generally to semiconductor rectifiers, and more specifically to a regenerative self-controlling mechanism for improving the performance of diode bridges, and methods therefor.

**BACKGROUND OF THE INVENTION**

Diode bridges, either full or half bridges, are very common circuit elements to perform rectification of oscillating output signal. A half bridge is made of two diodes and has three external electrodes. They are commonly used for the output rectification in switched-mode power supply circuits: e.g. in forward, push-pull, half bridge and full bridge topologies. For one polarity of the signal, electric current flows through one diode (in ON state) and not through the other (in OFF state). For the opposite polarity the diodes switch their states: the ON diode goes to OFF state and the OFF diode changes to ON state. This switching of the current flow between the two diodes results in rectification.

The energy loss during signal rectification is determined by the performance of individual diode. For the real diode implementation, it is limited by the ideal diode equation:

$$I_F / I_R \leq \exp(qV_F / kT),$$

where $I_F$ is a forward current, $V_F$ is the forward bias voltage, $I_R$ is the leakage current and $kT/q=0.0259V$ at room temperature T. Thus a certain rectification ratio requires that the forward voltage drop is larger than some limit

$$V_F > 0.0259 \ln(1 + I_F / I_R).$$

For example, for a diode conducting a current of 10A, with 10 μA leakage current, the forward voltage drop is larger than 0.358. Some diodes are close to this theoretical limit, leaving very small space for improvement through conventional techniques. This theoretical limit leads to very inefficient diodes once the electronics moves to lower voltages. For example, if a power supply uses 3.3V the losses on the half bridge will be about 0.358/3.3=11%. This high energy loss just for the rectification is unacceptable for modern switched-mode power supplies.

To overcome the high losses on rectifier bridges for low voltage applications, synchronous rectification is used. One approach is to use a MOSFET to perform the rectification function of the diode. However, the circuit implementation of synchronous rectification becomes very complicated. A controller is needed to provide the gate voltage and to change MOSFET from the ON to the OFF state. Sensors are needed to tell the controller that the sign of the applied voltage has changed. This additional signal processing reduces the speed of operation for half bridges made of synchronous rectifiers. Thus instead of 2 diodes, one needs a much more complicated and expensive circuit.

Thus, there has been a long-felt need for a bridge rectifier which can operate efficiently at low voltages, but without the complex circuitry and limited frequency range of conventional synchronous rectifiers.

US 2004/041619 discloses a MOS-gated circuit including a plurality of gated switches; and a driver circuit electrically coupled to the gated switches, the driver circuit configured to automatically prevent a simultaneous conduction of the gated switches if at least one of the gated switches is not capable of sustaining a reapplied voltage without conducting.

US 4962411 discloses a semiconductor with a current detecting function in which in place of an external resistor for detecting an operation current such as a drain current or collector current of a device such as an FET or bipolar transistor, a probe electrode is formed in proximity to the device depletion layer to connect therethrough with the device channel to generate a probe voltage corresponding to the operation current.

**SUMMARY OF THE INVENTION**

There is provided according to a first aspect a semiconductor device according to claim 1. There is provided according to a second aspect a method for manufacturing a semiconductor device according to claim 2.

**THE FIGURES**

Figure 1 illustrates in schematic form a 4-terminal regenerative building block (RBB) structure. The current flow between source and drain is controlled by the gate electrode. The Probe electrode can be used as additional current control or as a source of regenerative signal.

Figure 2 illustrates two RBB's as shown in Figure 1 combined to form a regenerative half bridge. The Probe electrode of each RBB is connected to the Gate electrode of the other RBB for automatic switching between ON and OFF states. In an embodiment, two n-type (p-type) RBB's will make a common anode (common cathode) regenerative half bridge.

Figure 3 illustrates common anode and common cathode half bridges combined into a full diode bridge. Current flow is shown by arrows.

Figure 4 graphically depicts forward voltage drop vs. applied current. Common anode (red) and common cathode (green) half bridges have a smaller voltage drop than the ideal diode (blue) with 20 uA leakage.

Figure 5 illustrates a schematic I-V curve for regenerative half-bridges in accordance with the invention. The negative resistance region corresponds to the automatic switching from OFF to ON state, when the gate voltage exceeds the threshold voltage.

Figure 6 depicts a regenerative Half Bridge Current doubler rectification design.

Figure 7 show current (green) and voltage (red) waveforms for a current doubler constructed in accordance with an aspect the invention. Forward recovery happens at 3 $\mu$s, and reverse recovery at 4 $\mu$s. The forward voltage drop in the middle is 0.05V.

Figure 8 depicts reverse recovery for a regenerative half bridge in accordance with the invention. The first negative peak corresponds to the transition of the RBB from ON to OFF state. The second negative peak corresponds to the transition of the adjacent RBB from OFF to ON state, when the voltage on the first RBB is big enough to switch it ON.

Figure 9 depicts a semiconductor structure according to an embodiment of the process of the invention, after vertical etching through insulating oxide, polysilicon gate and gate oxide (can leave some of gate oxide to reduce the channeling) using the Gate mask. Contact As implant has been made for source and probe electrodes.

Figure 10 illustrates a semiconductor structure after a probe mask is placed on the Gate mask to cover the Probe contact opening and the P-well boron implant has been made.

Figure 11 illustrates the semiconductor after isotropic ashing of the photoresist has been made to provide self-aligning mask for the next step.

Figure 12 illustrates the result after the channel boron implant has been made, that should uniformly affect the threshold voltage of the device.

Figure 13 illustrates the structure after both masks are removed.

Figure 14 illustrates the structure once the insulating oxide is deposited and an insulation mask is placed on top.

Figure 15 depicts the structure once a vertical oxide etch is performed.

Figure 16 illustrates the structure after a probe mask is placed to cover the probe contact and a trench is etched to provide contact to the P-well.

Figure 17 illustrates the structure after the photoresist is removed and the structure is ready for multilayer metallization.

Figure 18 schematically depicts a regenerative half bridge, not claimed, with common anode (cathode) made from two n-type (p-type) MOSFETs, configured to have the drain voltage applied to the gate. This configuration provides automatic switching between ON and OFF states during operation.

Figure 19 schematically depicts a regenerative half bridge, not claimed, made using one RBB and one MOSFET.

DETAILED DESCRIPTION OF THE INVENTION

The present invention comprises a new device which can be thought of as a regenerative building block (RBB), and methods of manufacture therefore. In an embodiment, the device is particularly suited to fabrication of devices such as half bridge and full bridge rectifiers. Although those skilled in the art will quickly recognize that the present invention can be used to create a variety of semiconductor devices, for purposes of clarity the present invention will be described in the context of a bridge rectifier, both as a device and as a method of manufacture.

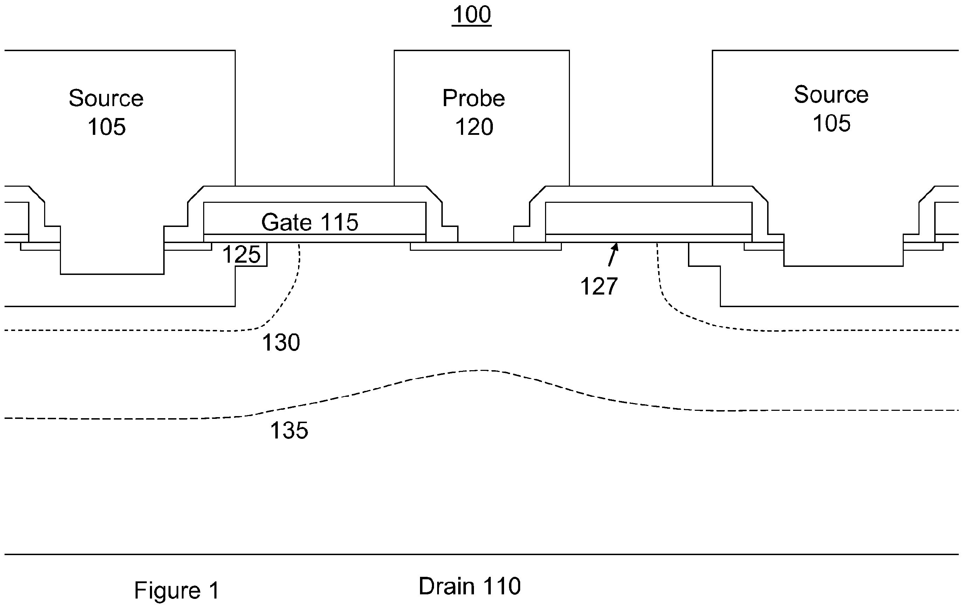

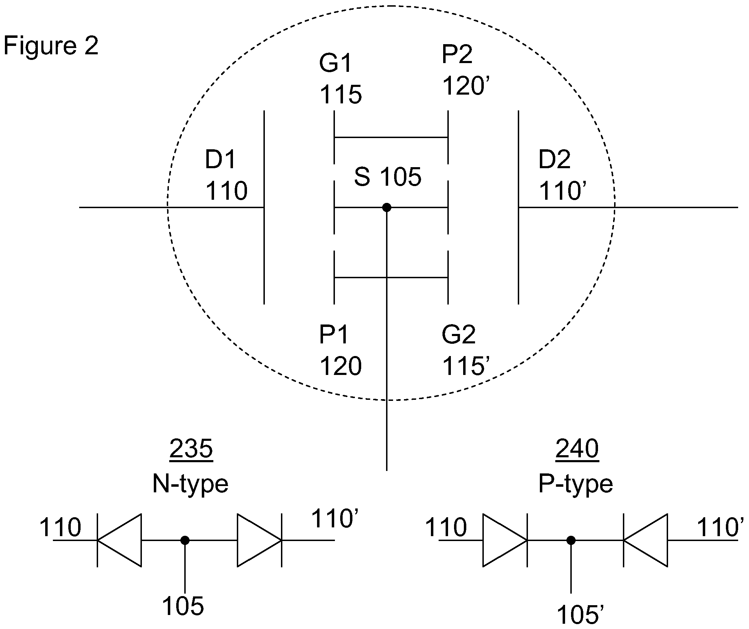

Referring first to Figures 1 and 2, the RBB structure indicated generally at 100 is shown both in terms of its physical structure (Figure 1) and its schematic representation in a pair configured as a half bridge rectifier (Figure 2). As shown in Figure 1, the RBB 100 has four electrodes: source 105, drain 110, gate 115 and probe 120. The main current flows between the source and drain electrodes. The gate voltage controls the conductivity of the narrow channel 125 under MOS gate 115 and can switch the RBB between OFF and ON states. The transition from ON to OFF happens at the threshold voltage, which can be adjusted either by using a doping profile under the gate or by changing the thickness of the gate oxide 127. The main purpose of the probe electrode 120 is to extract a regenerative signal, which can be used as a gate control signal for another semiconductor device, such as another RBB or MOSFET.

When the RBB 100 is in the ON state, the voltage drop between source 105 and drain 110 is small, leading to a small probe signal at 120. In the OFF state, the depletion layer boundary changes with the voltage applied between the source and drain. For the small applied voltage the depletion layer boundary 130 is located between the probe 120 and the source 105, and typically ends under the gate for a small applied voltage. In this state, the probe can be thought of in a practical sense as being essentially shorted to the drain, and the probe voltage follows the drain voltage. However for the large applied voltage the depletion layer boundary 135 extends beyond the probe electrode, the probe voltage is almost constant and is almost independent of the drain voltage. This makes the probe voltage attractive as a regenerative signal that can signal other devices whether the RBB 100 is in ON or OFF state. The maximum probe voltage can be adjusted at least by modifying the geometry (e.g. width) of the Probe contact 120 or by changing the doping profile under the Probe contact.

Turning more specifically to Figure 2, this figure shows how two RBB's 100 can be combined to make regenerative half bridge. The gate electrode 115 of each RBB is controlled by a regenerative signal from the probe contact 120 (and 120') of the other RBB. Note that the resulting regenerative half-bridges have only 3 external contacts, at the common source 105 (and 105'), and each drain 110 and 110', as if they were made out of regular diodes. This allows for substantially pin-for-pin replacement of diode bridges, but without the low voltage limitation of the prior art, and also without the need for the complex control circuitry characteristic of prior art synchronous rectifiers.

The RBB 100 can be n-type or p-type depending on the choice of the epitaxial layer doping. Each RBB has an intrinsic body diode, and for application in circuits typically replaces a diode with the same polarity . Thus two N-type RBB's can be combined into a common anode half-bridge 235, and two P-type RBBs make common cathode half-bridge 240, as shown at the bottom of Figure 2. During the half-bridge operation one of the devices stays ON while the other is OFF. The regenerative signal from the OFF device has the right sign to help the other device to stay ON.

In an embodiment, the thickness of the gate oxide and the doping in the channel region are carefully managed to optimize device performance. In addition, N++ doping in the probe opening is preferred over P++ doping in at least some embodiments.

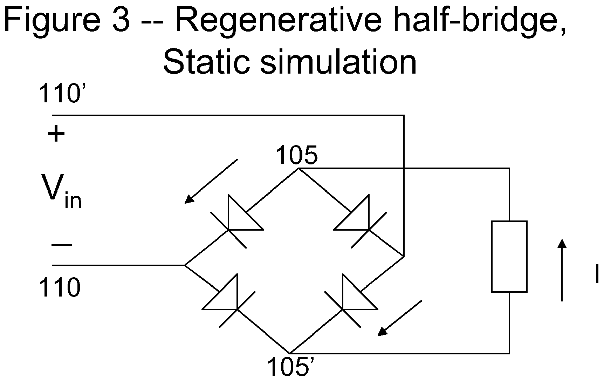

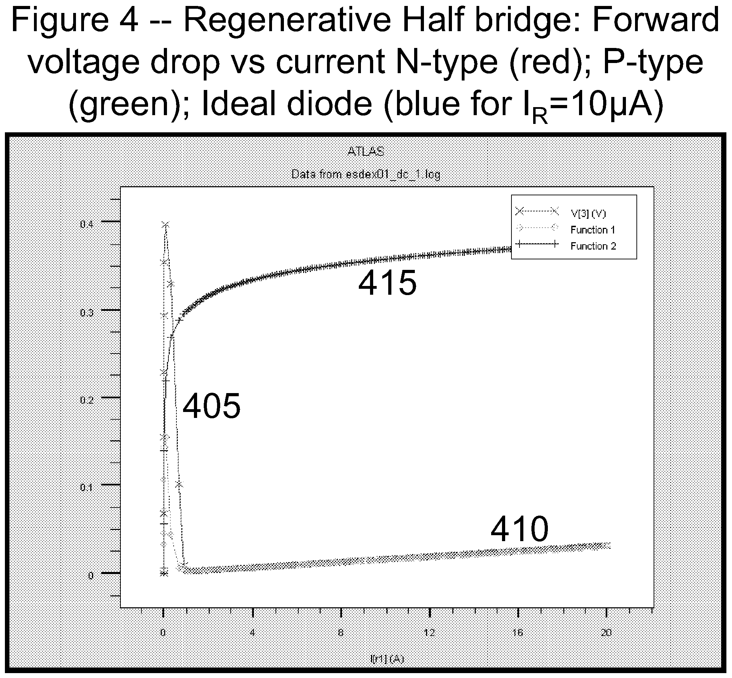

In testing the design shown in Figures 1 and 2, a full bridge was tested as shown in Figure 3, and was configured from common cathode and common anode half bridges as shown in Figure 2. The test results are shown on Figure 4. More specifically, the I-V curve of Figure 4 is for a 10A, 20V bridge, and shows the forward voltage on a diode (vertical axis) vs. voltage applied to the bridge. By using a 1 ohm load resistor, the current on the horizontal axis is practically equal to the full bridge input voltage. Forward voltage on a diode at 10A current (200 A/cm$^2$ current density for the n-type device, and 67 A/cm$^2$ for the p-type) is less than 0.05V. The curve 405 shows the result for the n-type device (used in common anode part of the full bridge) and the curve 410 shows the result for the p-type device (used in common cathode half bridge). The region 415 with the negative differential resistance corresponds to the device transition from OFF to ON state. Notice that at zero applied voltage all four RBB devices are in the OFF state. They stay in the OFF state during reverse bias, and automatically go to the ON state when the forward bias reaches approximately 0.5V. The typical leakage of corresponding devices in the OFF state is on the order of 60 μA and 160 μA. Leakage can be reduced at the expense of higher VF by changing the doping concentration under the MOS gate or by changing the geometrical parameters of the structure.

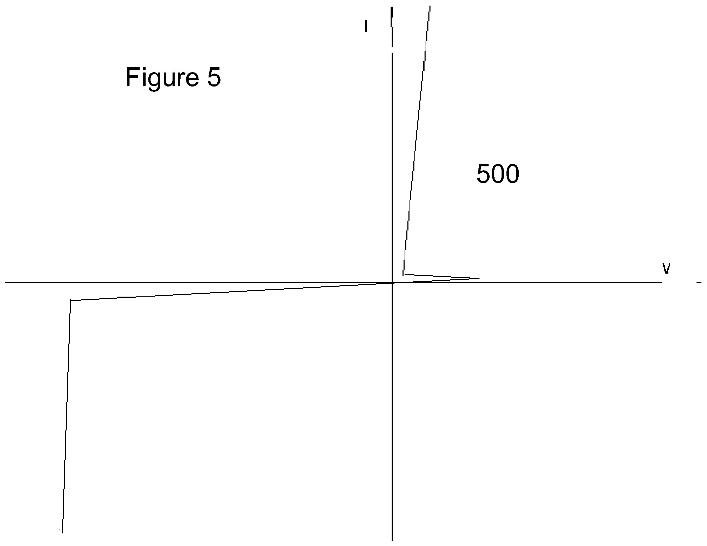

The schematic I-V curve for our device operation in all quadrants is shown at 500 in Figure 5. It looks like a regular diode I-V curve, except for the negative resistance region, which is a result of device physics. The shape of the curve as a whole, including the negative resistance region, depends on geometry and the doping concentrations of the constituent RBB's and therefore is adjustable for an individual RBB.

It can therefore be appreciated that the performance characteristics of this bridge are similar to the one that can be made with synchronous rectifiers, but the device of the present invention does not need either a controller or the circuit associated with the controller implementation typically required of synchronous rectifiers. The transient behavior of the RBB's 100 can be optimized to provide maximum frequency operation with minimum EMI by changing doping profiles and devices geometries, including particularly channel boron dosage, gate oxide thickness, and the width of the probe opening. The transient behavior typically is impacted by the gate capacitance, since carriers are accumulated under the gate during forward bias. The gate oxide on the RBB can be thinned, or, as discussed hereinafter, removal of part of the gate during processing assists in compensating for any capacitance increase. From the foregoing, it can be appreciated that the regenerative half bridges of the present invention do not need additional circuit elements and, due to their improved performance relative to the art, also permit increased frequency of operation.

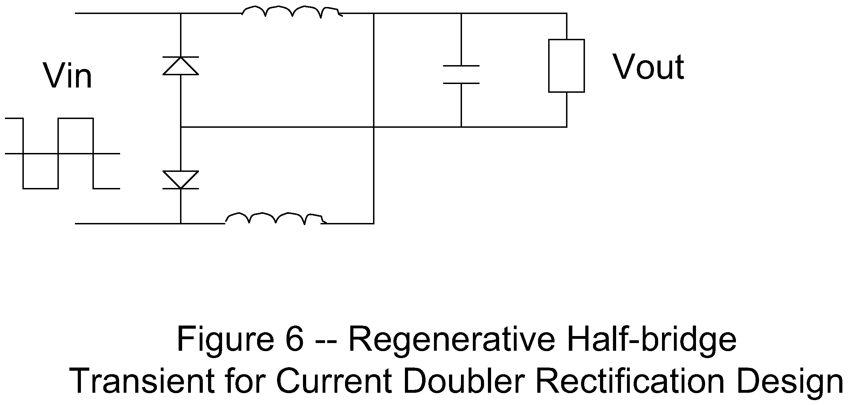

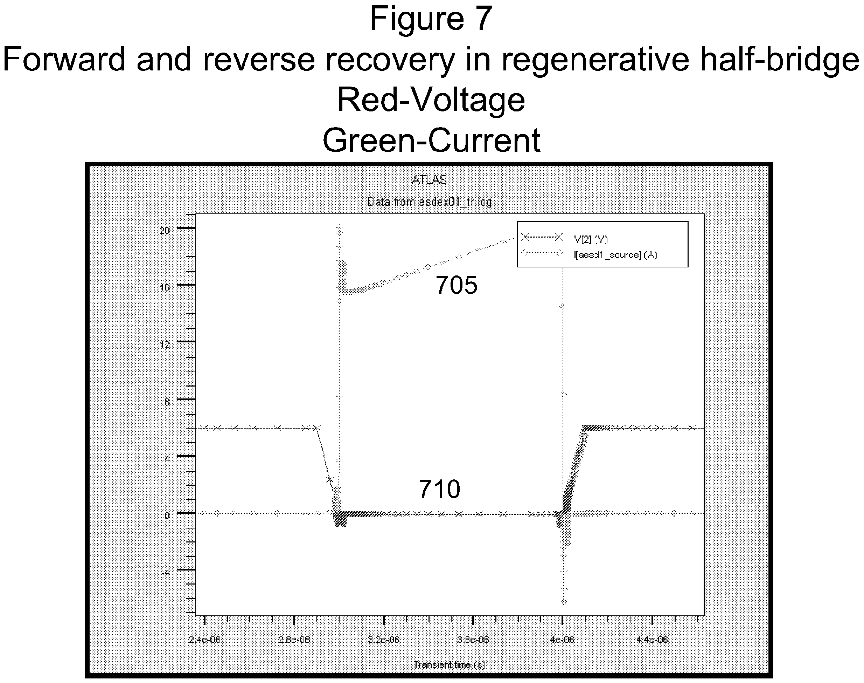

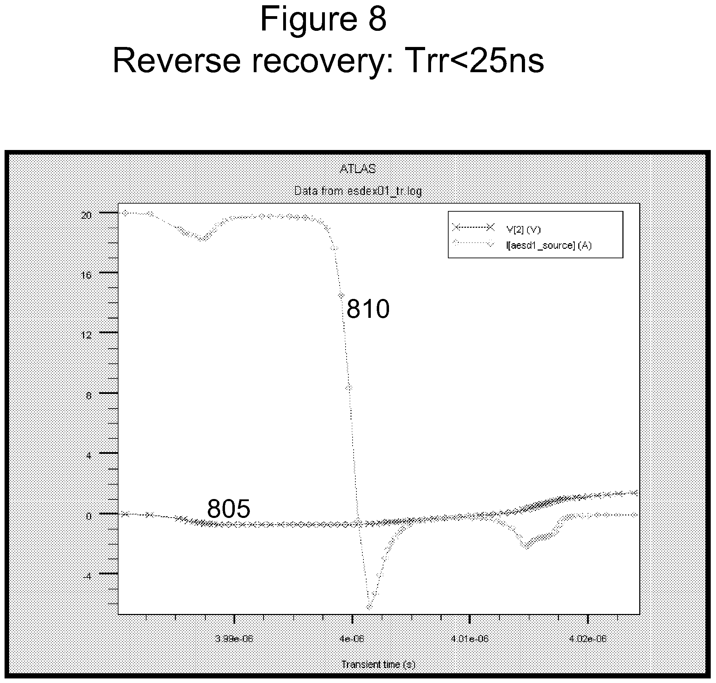

The dynamic behavior of the common anode half bridge has been tested for the current doubler rectification circuit shown in Figure 6. This circuit can be used for the output signal rectification and filtering in several switch mode power supply topologies. Typical waveforms for current 705 and voltage 710 are shown on Figure 7 for one cycle of operation. The forward and reverse recoveries do not exhibit significant spikes. Details of reverse recovery are shown on Figure 8, demonstrating that transient time is small. Voltage is shown by curve 805, and current is shown by curve 810.

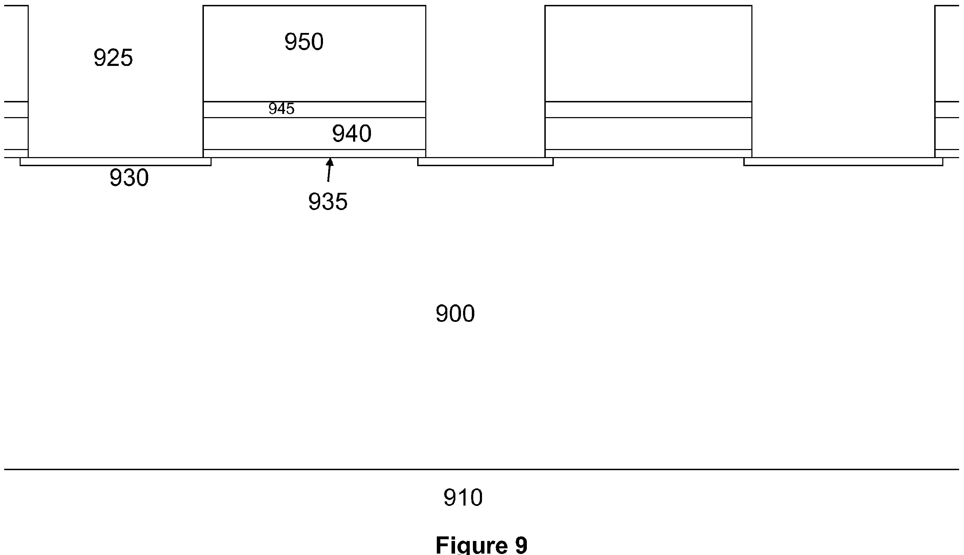

One possible way to manufacture the RBB is described below in Figures 9-17. Those skilled in the art will recognize numerous alternative approaches, and thus the present invention is not limited to the specific method of manufacture described hereinafter. In addition, isolation of the device is desirable in at least some embodiments, and such isolation, if desired, can be achieved by use of a guard ring structure, isolators, or other structures, depending upon the application. These structures are well known in the art, and so are not described here. Further, it is desirable, in at least some embodiments, to have the MOS channel area be uniform throughout the device. One approach for achieving this is to use a self-aligning processing as discussed below.

First, an epitaxial layer 900 is grown on a substrate 910. The doping concentration (N- or P-type) and thickness of this epitaxial layer depends on the breakdown voltage and the desired device type. For the sake of clarity, the following discussion describes the process for an N-type device, which is complementary to the P-type process.

Following the growth of the epitaxial layer 900 a gate oxide 935 on the order of 30-200A is made, followed by fabricating a layer 940 of Polysilicon on the order of 600-1200A. Then, an insulating oxide layer 945 is laid down, on the order of 50-1500A thick. The gate mask 950 is then developed, followed by vertically etching the insulating oxide, polysilicon and gate oxide. Contacts for the source and probe 930 electrodes are made using As implantation through the opening 925. The structure at this stage is shown in Figure 9.

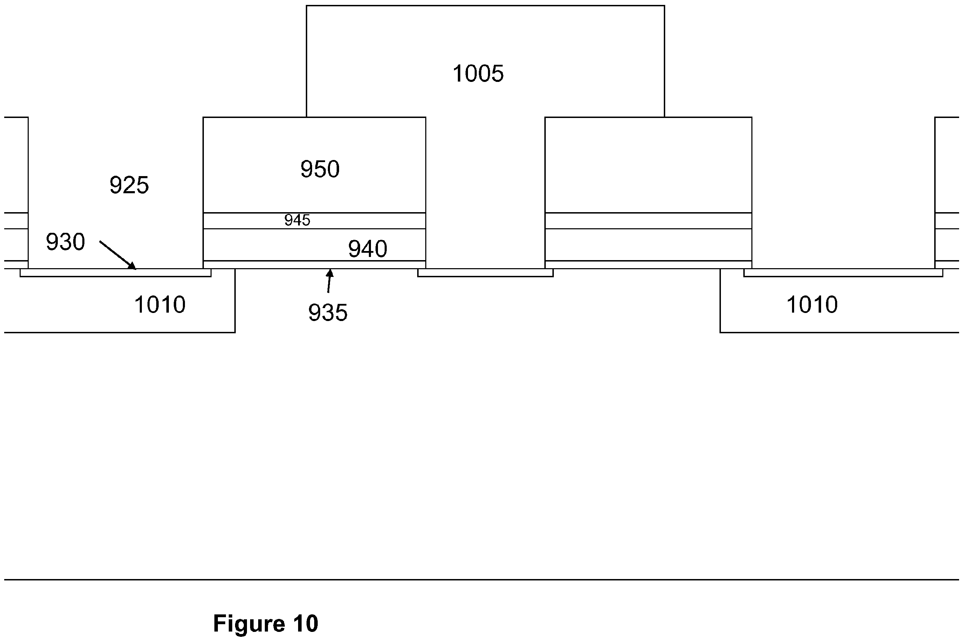

As shown in Figure 10, a second Probe mask 1005 is then made on top of the Gate mask, using any suitable method such as silicon nitride or other material. This mask arrangement provides self-alignment and results in uniform barrier heights in the MOS channel area. The P-well boron 1010 is also implanted. For at least some embodiments, the dose of P-well boron is preferably high enough to restrict the main current flow through the channel area.

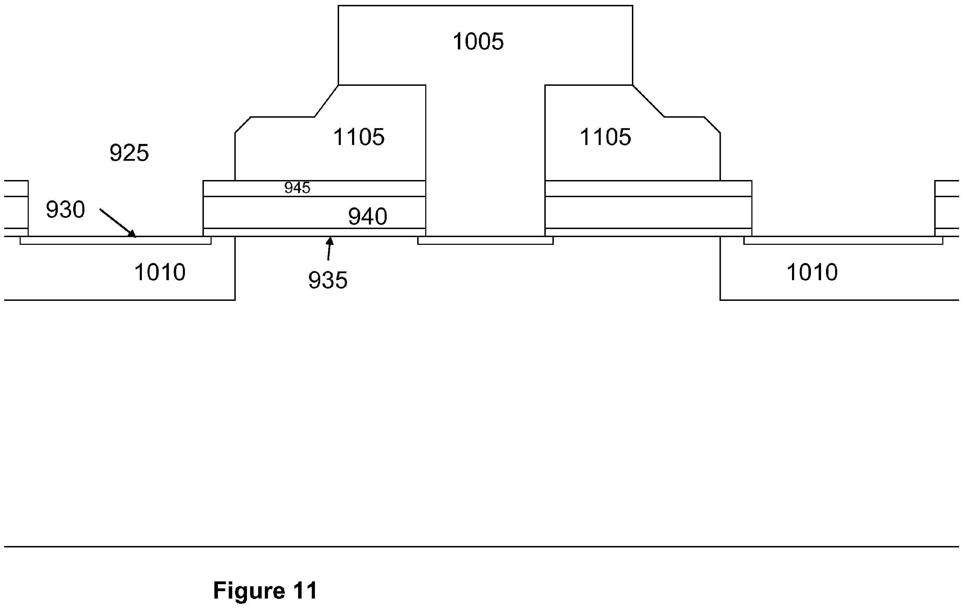

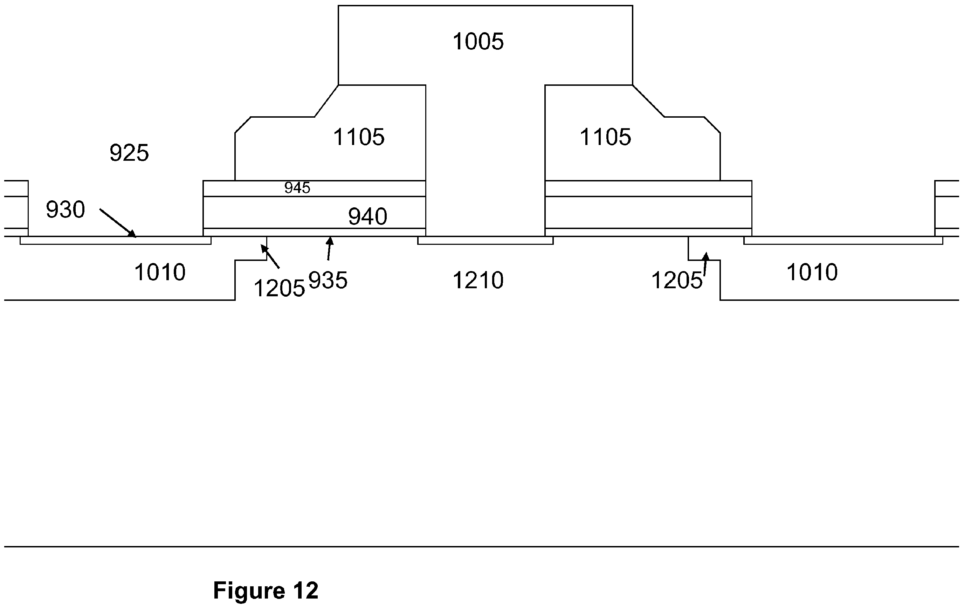

The Gate mask is isotropically etched as shown in Figure 11 at 1105. This provides a self-aligned mask for the channel boron implantation 1205, as shown in Figure 12. The Probe mask is also etched at this stage, and typically covers the adjustment area indicated at 1210.

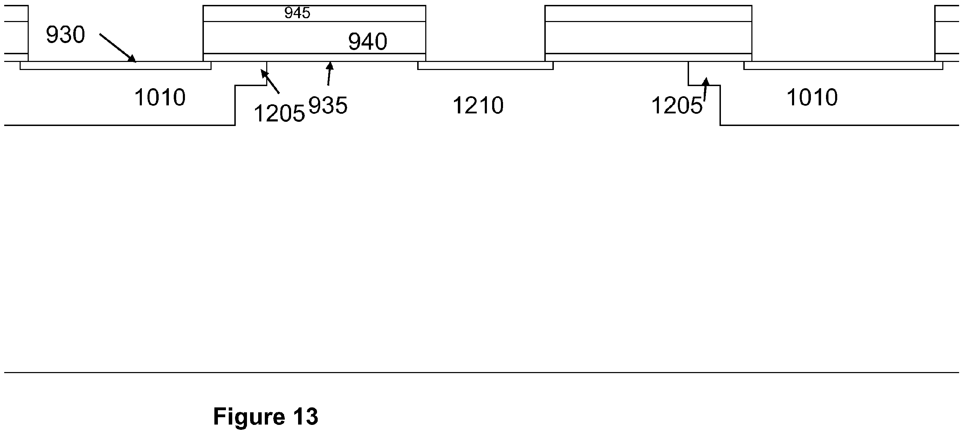

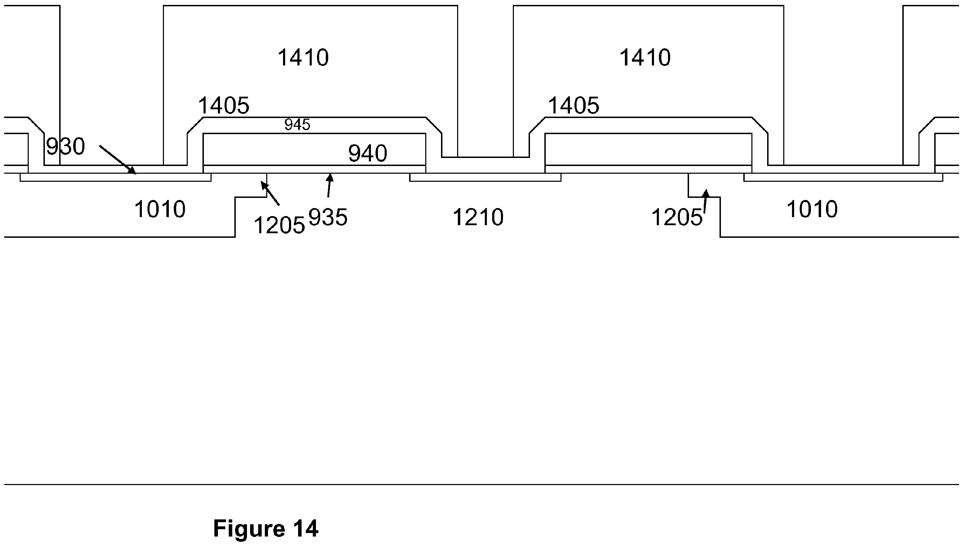

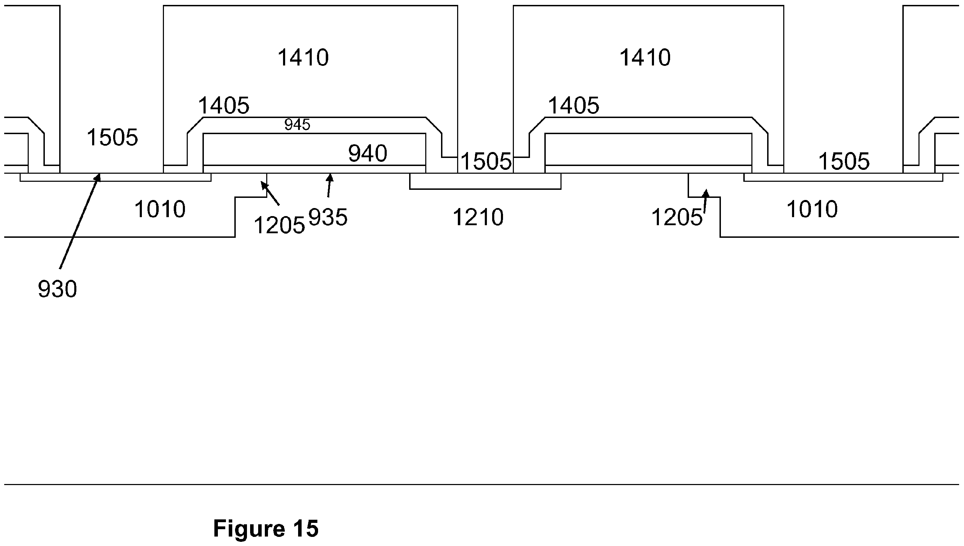

Next, as shown in Figure 13, the Gate and Probe masks are removed, and an insulating oxide 1405 is deposited and an insulation mask 1410 is placed on top as shown in Figure14. Then, as shown in Figure 15, the insulating oxide is etched as indicated at 1505 to provide contacts to the probe and source electrodes.

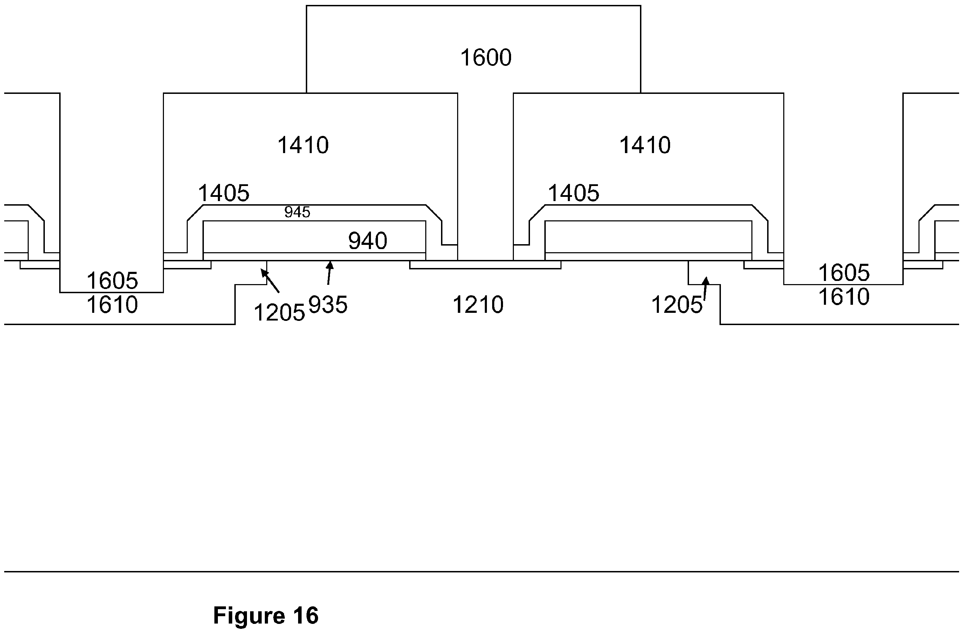

Then, a Probe mask 1600 is placed on top of the insulation mask. A trench 1605 shown in Figure 16 is vertically etched in silicon to provide contact to the P-well, and a P-type implant 1610 is performed to provide ohmic contact for the Source electrode. Otherwise, in some embodiments, the charge in the P-well will be changed by the hole current that flows to the anode through the P-wells of the guard ring structure. This may slow down device operation, unless the distance to the guard ring's P-well is small enough. Notice that there is still a good ohmic contact for the electron flow, since most of the electron current is flowing through the narrow channel under the gate.

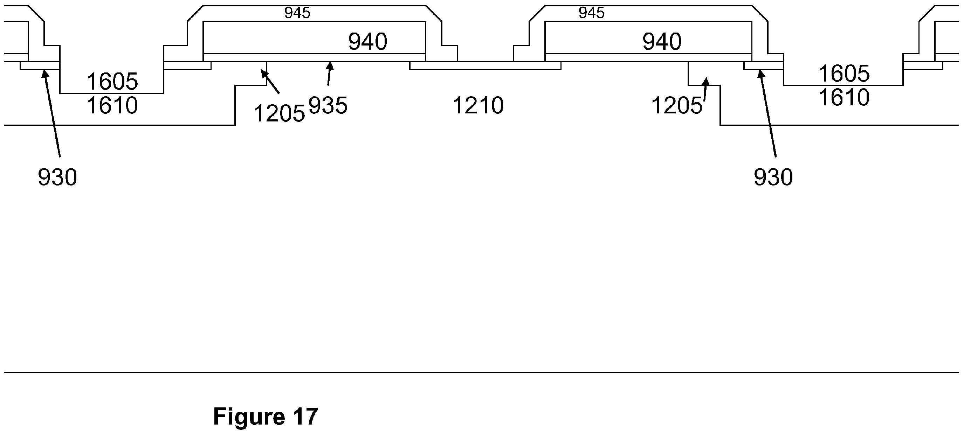

Referring next to Figure 17, removal of the photoresist concludes the active area processing. Multilayer metallization is then performed in a conventional manner as for MOSFET devices, and is therefore not shown, such that three contact areas are created on the top surface of the chip to conclude the RBB manufacturing process and yield the device shown in Figure 1.

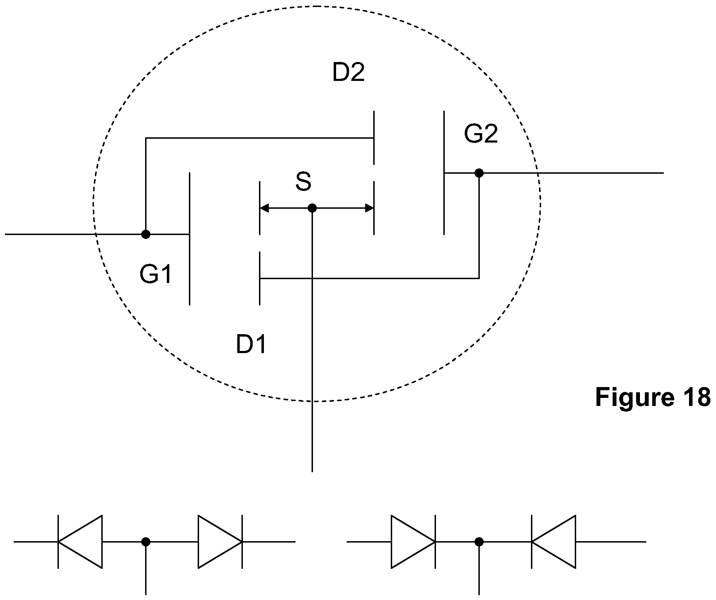

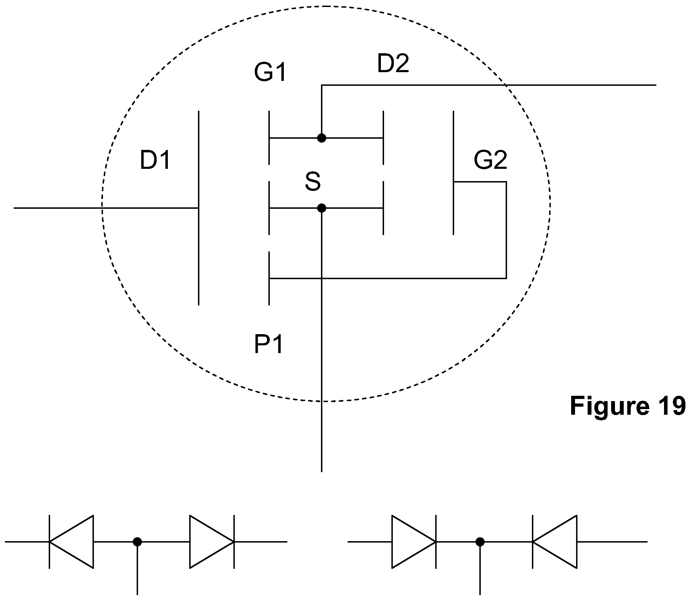

In principal it is not always necessary to use RBB to make regenerative half bridges or diodes. For example, for the low breakdown voltage devices the full drain voltage can be used as a probe voltage. Then regenerative half bridges can be made from 2 MOSFETs (Figure 18) or from a combination of RBB and MOSFET (Figure 19). Notice, that to operate at small voltages the MOSFET should have small threshold voltage and therefore small gate oxide thickness. Thus, for handling significant power, practically one cannot apply full drain voltage to the low threshold gate, since the thin gate oxide might be damaged and the device destroyed. For lower power devices, such as those incorporated into integrated circuits, which typically have all three terminals on the top surface, full drain voltage can be applied to the gate in many realisations.

Having fully described a preferred embodiment of the invention and various alternatives, those skilled in the art will recognize, given the teachings herein, that numerous alternatives and equivalents exist which do not depart from the invention.

**Claims**

1. A semiconductor device operable as a half bridge comprising
a first drain contact (110), contacting a first drain, a first source region, a first gate (115) for controlling the current flow between the first drain and the first source region, and a first probe region (120), a second drain contact (110'), contacting a second drain, a second source region, a second gate (115') for controlling the current flow between the second drain and the second source region, and a second probe region (120'),
a first source (105) contact, **characterised in that**:

the first probe region (120) is connected to the second gate (115'), said first probe region (120) configured to provide a first regenerative, gate control signal for the second gate (115'),
the second probe region (120') is connected to the first gate (115) said second probe region (120') configured to provide a second regenerative, gate control signal for the first gate (115'),
the first source region is connected to the second source region, and to the first source contact (105).

2. A method for manufacturing a semiconductor device comprising the steps of

depositing first and second source structures in a first substrate (100), depositing a first gate (115) on the first substrate (100), attaching a first drain contact (110) on the first substrate (100), and

depositing a first probe structure (120) between the first and second source structures, depositing third and fourth source structures in a second substrate; depositing a second gate (115') on the second substrate; attaching a second drain contact (110') on the second substrate;

depositing a second probe structure (120') between the third and fourth source structures; **characterised by** connecting the first probe structure (120) to the second gate (115') such that the first probe structure (120) is configured to provide the second gate (115') with a first regenerative, gate control signal; connecting the second probe structure (120') to the first gate (115) such that the second probe structure (120') is configured to provide the first gate (115) with a second regenerative, gate control signal; and connecting said first and second source structures to said third and fourth source structures and a first source contact (105).

## Patentansprüche

1. Halbleiterbauelement, das als Halbbrücke betrieben werden kann, umfassend

einen ersten Drain-Kontakt (110) mit Kontakt zu einem ersten Drain, einer ersten Source-Region, einem ersten Gate (115) zum Steuern des Stromflusses zwischen dem ersten Drain und der ersten Source-Region, und einer ersten Sondenregion (120),

einen zweiten Drain-Kontakt (110') mit Kontakt zu einem zweiten Drain, einer zweiten Source-Region, einem zweiten Gate (115') zum Steuern des Stromflusses zwischen dem zweiten Drain und der zweiten Source-Region, und einer zweiten Sondenregion (120'),

einen ersten Source-Kontakt (105), **dadurch gekennzeichnet, dass**:

die erste Sondenregion (120) mit dem zweiten Gate (115') verbunden ist, wobei die genannte erste Sondenregion (120) zum Bereitstellen eines ersten regenerativen Gate-Steuersignals für das zweite Gate (115') konfiguriert ist,

die zweite Sondenregion (120') mit dem ersten Gate (115) verbunden ist, wobei die genannte zweite Sondenregion (120') zum Bereitstellen eines zweiten regenerativen Gate-Steuersignals für das erste Gate (115') konfiguriert ist,

die erste Source-Region mit der zweiten Source-Region und mit dem ersten Source-Kontakt (105) verbunden ist.

2. Verfahren zur Herstellung eines Halbleiterbauelements, das die folgenden Schritte beinhaltet:

Absetzen von ersten und zweiten Source-Strukturen in einem ersten Substrat (100),

Absetzen eines ersten Gate (115) auf dem ersten Substrat (100),

Anbringen eines ersten Drain-Kontakts (110) an dem ersten Substrat (100), und

Absetzen einer ersten Sondenstruktur (120) zwischen der ersten und zweiten Source-Struktur,

Absetzen einer dritten und vierten Source-Struktur in einem zweiten Substrat;

Absetzen eines zweiten Gate (115') auf dem zweiten Substrat;

Anbringen eines zweiten Drain-Kontakts (110') an dem zweiten Substrat;

Absetzen einer zweiten Sondenstruktur (120') zwischen der ersten und vierten Source-Struktur;

**gekennzeichnet durch**

Verbinden der ersten Sondenstruktur (120) mit dem zweiten Gate (115'), so dass die erste Sondenstruktur (120) zum Versorgen des zweiten Gate (115') mit einem ersten regenerativen Gate-Steuersignal konfiguriert ist;

Verbinden der zweiten Sondenstruktur (120') mit dem ersten Gate (115), so dass die zweite Sondenstruktur (120') zum Versorgen des ersten Gate (115) mit einem zweiten regenerativen Gate-Steuersignal konfiguriert ist; und

Verbinden der genannten ersten und zweiten Source-Struktur mit der genannten dritten und vierten Source-Struktur und einem ersten Source-Kontakt (105).

## Revendications

1. Dispositif à semiconducteur servant de demi-pont comportant

une première borne de drain (110), en contact avec un premier drain, une première région de source, une première grille (115) servant à commander la circulation du courant entre le premier drain et la première région de source, et une première région de sonde (120),

une deuxième borne de drain (110'), en contact avec un deuxième drain, une deuxième région de source, une deuxième grille (115') servant à commander la circulation du courant entre le deuxième drain et la deuxième région de source, et une deuxième région de sonde (120'),

une première borne de source (105), **caractérisé en ce que** :

la première région de sonde (120) est connectée à la deuxième grille (115'), ladite première région de sonde (120) étant configurée pour fournir un premier signal de commande de grille de rétroaction pour la deuxième grille (115'),
la deuxième région de sonde (120') est connectée à la première grille (115), ladite deuxième région de sonde (120') étant configurée pour fournir un deuxième signal de commande de grille de rétroaction pour la première grille (115')
la première région de source est connectée à la deuxième région de source, et à la première borne de source (105).

2. Procédé de fabrication d'un dispositif à semiconducteur comportant les étapes consistant à
déposer des première et deuxième structures de source dans un premier substrat (100),
déposer une première grille (115) sur le premier substrat (100),
attacher une première borne de drain (110) sur le premier substrat (100), et
déposer une première structure de sonde (120) entre les première et deuxième structures de source,
déposer des troisième et quatrième structures de source dans un deuxième substrat ;
déposer une deuxième grille (115') sur le deuxième substrat ;
attacher une deuxième borne de drain (110') sur le deuxième substrat ;
déposer une deuxième structure de sonde (120') entre les troisième et quatrième structures de source ;
**caractérisé par** les étapes consistant à
connecter la première structure de sonde (120) à la deuxième grille (115') de telle sorte que la première structure de sonde (120) est configurée pour fournir à la deuxième grille (115') un premier signal de commande de grille de rétroaction ;
connecter la deuxième structure de sonde (120') à la première grille (115) de telle sorte que la deuxième structure de sonde (120') est configurée pour fournir à la première grille (115) un deuxième signal de commande de grille de rétroaction ; et
connecter lesdites première et deuxième structures de source auxdites troisième et quatrième structures de source et à une première borne de source (105).

**100**

Source
105

Probe
120

Source
105

Gate 115

125

127

130

135

Figure 1

Drain 110

EP 2 240 960 B1

Figure 2

G1
115

P2
120'

D1
110

S 105

D2
110'

P1
120

G2
115'

235
N-type

110    110'

105

240
P-type

110    110'

105'

# Figure 3 -- Regenerative half-bridge, Static simulation

EP 2 240 960 B1

# Figure 4 -- Regenerative Half bridge: Forward voltage drop vs current N-type (red); P-type (green); Ideal diode (blue for $I_R$=10µA)

Figure 5

500

Figure 6 -- Regenerative Half-bridge
Transient for Current Doubler Rectification Design

EP 2 240 960 B1

# Figure 7
## Forward and reverse recovery in regenerative half-bridge
## Red-Voltage
## Green-Current

EP 2 240 960 B1

# Figure 8
## Reverse recovery: Trr<25ns

ATLAS

Data from esdex01_tr.log

V[2] (V)
I[aesd1_source] (A)

810

805

3.99e-06    4e-06    4.01e-06    4.02e-06

Transient time (s)

EP 2 240 960 B1

**Figure 9**

900

910

925

930

935

940

945

950

**Figure 10**

EP 2 240 960 B1

1005

1105

1105

925

930

945

940

1010

935

1010

**Figure 11**

**Figure 12**

**Figure 13**

EP 2 240 960 B1

**Figure 14**

**Figure 15**

EP 2 240 960 B1

**Figure 16**

**Figure 17**

EP 2 240 960 B1

Figure 18

Figure 19

**REFERENCES CITED IN THE DESCRIPTION**

**Patent documents cited in the description**

- US 20040041619 A
- US 4962411 A